# EUROPÄISCHE PATENTSCHRIFT

(11) **EP 3 508 040 B1**
(45) Veröffentlichungstag und Bekanntmachung des Hinweises auf die Patenterteilung: **30.09.2020**
(21) Anmeldenummer: 17758820.9
(22) Anmeldetag: 10.08.2017
(51) Int. Cl.: H05K 1/02, H05K 1/09, H05K 3/24, H05K 3/34, H05K 3/38, H05K 3/42, H05K 3/06

(54) **LEITERPLATTE UND VERFAHREN ZU DEREN HERSTELLUNG**
PRINTED CIRCUIT BOARD AND PROCESS TO MANUFACTURE A PRINTED CIRCUIT BOARD
CIRCUIT IMPRIMÉ ET PROCÉDÉ DE FABRICATION D'UN CIRCUIT IMPRIMÉ

(30) Priorität: 30.08.2016 DE 102016216308
(43) Veröffentlichungstag der Anmeldung: 10.07.2019
(73) Patentinhaber: Schweizer Electronic AG, 78713 Schramberg (DE); Vitesco Technologies GmbH, 30165 Hannover (DE)
(72) Erfinder: TRAGESER, Hubert, 91338 Igensdorf (DE); NEUMANN, Alexander, 78628 Rottweil (DE)
(74) Vertreter: Glawe, Delfs, Moll
(86) Internationale Anmeldenummer: PCT/EP2017/070360
(87) Internationale Veröffentlichungsnummer: WO 2018/041595

(56) Entgegenhaltungen:
- US-A1- 2010 078 208
- US-A1- 2011 253 431

## Beschreibung

### Technisches Gebiet

Die vorliegende Erfindung betrifft eine Leiterplatte sowie ein Verfahren zur Herstellung einer Leiterplatte.

### Beschreibung des Standes der Technik

Leiterplatten werden beispielsweise in Kraftfahrzeugen zur elektronischen Regelung und Steuerung eines Fahrzeuggetriebes eingesetzt. Üblicherweise sind die Leiterplatten hier als starre Leiterplatten ausgebildet, die einerseits diskrete Bauelemente und hochintegrierte Bausteine elektrisch miteinander verbinden und andererseits als Träger derselben dienen.

Die Leiterplatten bestehen dazu aus einer oder mehreren Substratlagen aus glasfaserverstärkten, ausgehärteten Epoxidharz, die zur Ausbildung von elektrisch leitenden Strukturen, insbesondere Leiterbahnen ein- oder beidseitig kupferkaschiert sind. Bei mehrlagigen Leiterplatten werden eine oder mehrere dieser Substratplatten mittels sogenannter Prepregs und teilweise auch zusätzlich mit Kupferfolien verpresst. Die Substratplatten und Prepregs bilden elektrisch isolierende Substratlagen der mehrlagigen Leiterplatte.

Die isolierten Leiterbahnen zwischen elektrisch isolierenden Substratlagen werden durch metallisierte Bohrungen, auch als Durchkontaktierung bekannt, in der Leiterplatte elektrisch miteinander verbunden. Die verschiedenen Herstellungsverfahren von Durchkontaktierungen sind aus dem Stand der Technik bekannt. Üblicherweise wird zuerst ein Loch durch mehrere elektrisch isolierende Substratlagen der Leiterplatte gebohrt, welches gereinigt wird. Anschließend wird die nichtleitende Bohrlochwandung elektrisch leitfähig gemacht, bevor eine galvanische Kupferverstärkung folgt. Eine weitere Ausführungsvariante einer elektrischen Verbindungsmöglichkeit von isolierten Leiterbahnen sind Sacklöcher.

Im Betrieb der Leiterplatte erzeugen dauerhaft anliegende hohe Gleichspannungen bei Versorgungspotenzialen statische elektrische Felder auch im Isolationsmaterial (FR4) innerhalb der Leiterplatte. Die elektrischen Felder verursachen eine Kupfer-Ionen-Migration in das Isolationsmaterial hinein. Daraus im Laufe der Zeit entstehende Ablagerungen können zu gefährlichen Durchschlägen durch die Isolationsschicht führen. Da durch die Ablagerungen leitfähige Fasern ausgehend von einer Kathode einer Schaltung der Leiterplatte bilden und unterhalb einer Substratlagenoberfläche in Richtung einer Anode der Schaltung wachsen, wird dieses Phänomen in der Fachwelt als CAF (für Conductive Anodic Filament) bezeichnet. Die Bildung solcher leitfähiger Fasern kann somit zu einem Kurzschluss zwischen mindestens zwei Leiterbahnen und damit zu einer Beschädigung bis hin zu einer Zerstörung der Leiterplatte führen.

Notwendig für das Entstehen der leitfähigen Fasern sind ein verminderter Verbund der Substratplatten (z.B. bei glasfaserverstärkten Epoxidharzplatten) und elektrochemische Korrosion. Ein verminderter Verbund kann beispielsweise durch mechanischen Stress, thermischen Stress und/oder Feuchtigkeit auftreten. Die elektrochemische Korrosion wird insbesondere durch vorhandene Feuchtigkeit gefördert.

Die Fachwelt versucht bislang, das Auftreten dieses Phänomens durch Einhalten von Designregeln, wie bspw. das Einhalten von Mindestabständen, einzuschränken (vgl. bspw. "Gefährlicher Kurzschluss im BCP bei hohen Spannungen" von Dirk Müller, Elektronikpraxis Nr. 19 vom 6.10.2014, Seiten 54 bis 56) .

Aus der DE 10 2011 082 537 A1 ist es zum Schutze von in aggressiver Umgebung (wie bspw. in Getriebeöl) zum Einsatz kommenden Leiterplatten bekannt, auf der Oberfläche angeordnete Kupferflächen zum Bestücken mit elektrischen Komponenten bzw. Kupferflächen zum elektrischen Verbinden von mindestens zwei Schichten der Leiterplatte sowie freiliegende Leiterbahnen mit einem weiteren Metall zu beschichten.

### Zusammenfassung der Erfindung

Ausgehend hiervon werden erfindungsgemäß eine Leiterplatte mit den Merkmalen des Anspruchs 1 sowie ein Verfahren zum Herstellen einer Leiterplatte mit den Merkmalen des Anspruchs 7 vorgeschlagen.

Der Erfindung liegt der Gedanke zugrunde, zur Reduzierung des Risikos des Auftretens des beschriebenen CAF-Effekts die leitenden Kupferschichten einer Leiterplatte zumindest beidseitig mit einer die Elektromigration hemmenden Materialschicht zu versehen. Dabei ist es unmaßgeblich, ob die Kupferschicht an der Oberfläche der Leiterplatte oder anderweitig freiliegend ist (bspw. eine Kupferbeschichtung einer durchgehenden Bohrung der Leiterplatte) oder ob es sich um eine innenliegende oder "vergrabene" Kupferschicht handelt. Auf zumindest einer der beidseitig aufgebrachten Hemmschichten ist eine weitere Metallschicht vorgesehen, bspw. zur Verstärkung und/oder Verbesserung der Leitungseigenschaften. Auf dieser weiteren Metallschicht ist ebenfalls eine Hemmschicht aufgebracht.

Unter beidseitig im vorliegenden Sinne sind dabei die beiden sich senkrecht zur Erstreckungsrichtung der Kupferschicht erstreckenden Oberflächen zu verstehen.

Zusätzlich kann vorgesehen sein, auch die Flanken der Kupferschichten mit einem die Elektromigration hemmenden Material zu beschichten, so dass eine allseitige Beschichtung mit einer Hemmschicht realisiert ist. Dabei kann es sich um dasselbe Material wie bei den Hemmschichten auf den beiden Oberflächen der jeweiligen Kupferschicht handeln, es kann sich aber auch um andere Materialien handeln, wie nachfolgend anhand von Ausführungsbeispielen noch näher erläutert wird.

Erfindungsgemäß wird somit mindestens eine der leitenden Kupferschichten einer Leiterplatte beidseitig mit einer Lage aus einem Material beschichtet, das eine die Elektromigration hemmende Wirkung hat. Geeignete Materialien umfassen bspw. Zink oder Messing (Kupfer-Zink-Legierung) oder Nickel bzw. eine Nickel-Verbindung (bspw. NiP). Nickel bzw. Nickel-verbindungen können bspw. in Schichtabfolgen mit anderen geeigneten Materialien eingesetzt werden, wie bspw. Nickel-Gold oder Nickel-Palladium-Gold. Auch Zinn oder andere mehr kommen als Hemmschicht-Materialien in Betracht. Auch nichtmetallische Materialien können grundsätzlich in Frage kommen, wie bspw. Polyamid o.a. Die Auswahl eines geeigneten Materials liegt im Bereich des fachmännischen Könnens im Hinblick auf die konkreten Anforderungen der fraglichen Leiterplatte bzw. unter Berücksichtigung verfahrenstechnischer Anforderungen.

Die Erfindung beruht auf der Erkenntnis, dass eine Unterbindung (Reduzierung oder Ausräumung) des CAF-Effekts möglich ist, wenn die dem CAF-Effekt zugrundeliegende Elektromigration, d.h. das Migrieren bzw. Diffundieren von Ionen aus dem Leitermaterial aufgrund einer Anoden-/Kathodenwirkung zweier in oder auf der Leiterplatte angeordneter leitender Kupferschichten, verhindert oder zumindest erschwert wird. Dies wird durch Einrichtung einer Barriere in Form einer Schicht aus einem die Elektromigration hemmenden Material erreicht (Hemmschicht). Diese Hemmschicht ist auf beiden Seiten der leitenden Kupferschicht vorzusehen, da insbesondere bei innenliegenden Kupferschichten eine Potentialdifferenz auf beiden Seiten der Kupferschicht auftritt bzw. auftreten kann.

Die voranstehenden Ausführungen gelten sowohl für außenliegende als auch (insbesondere) innenliegende leitende Kupferschichten, sowohl als Leiterbahnen als auch als durchgehende oder vergrabene Bohrungen in einem Mehrschichtaufbau.

Mittels der Erfindung wird es ermöglicht, eine dünne Hemmschicht, z.B. mit einer Schichtdicke im Bereich mehrerer hundert Nanometer, auf (innenliegenden) elektrisch leitenden Kupferstrukturen aufzubringen, mittels welcher der eingangs genannte CAF-Effekt zuverlässig vermeidbar oder zumindest das Risiko eines CAF-Effekts signifikant verringerbar ist. Damit ist die Lebensdauer der Leiterplatte gegenüber dem Stand der Technik erhöht.

Mit innenliegenden Kupferstrukturen sind insbesondere die bei mehrlagigen Leiterplatten zwischen den Substratlagen angeordneten Kupferstrukturen und/oder Durchkontaktierungen gemeint. Bei doppelseitigen Leiterplatten können ebenfalls Durchkontaktierungen oder andere durch die Substratlage verlaufende Kupferstrukturen gemeint sein.

Gemäß einer Ausgestaltung der Erfindung ist eine Mehrzahl von Substratlagen vorgesehen, wobei die Kupferschichten bzw. -strukturen zwischen den Substratlagen mittels mindestens einer Durchkontaktierung und/oder mindestens einer vergrabenen Bohrung elektrisch leitend miteinander verbunden sind. Dabei ist jeweils eine Bohrung für die mindestens eine Durchkontaktierung bzw. für die mindestens eine vergrabene Bohrung mit einer Hemmschicht versehen. Damit ist das Risiko des Auftretens eines CAF-Effektes weiter verringert.

Auf der Hemmschicht der Bohrung bzw. Durchkontaktierung ist eine weitere Metallschicht zur Erhöhung einer elektrischen Leitfähigkeit der Durchkontaktierung bzw. der vergrabenen Bohrung aufgebracht.

Eine Minimierung des CAF-Risikos wird erzielt, indem die jeweils oberste Hemmschicht die darunter liegenden Kupfer- und Metallschichten vollständig umgibt, d. h. auch deren Seitenflächen abdeckt.

Die Hemmschichten der innenliegenden elektrisch leitenden Kupferstrukturen und der Durchkontaktierung können sowohl im Material gleich als auch verschieden ausgebildet sein. Bei der Auswahl des Materials für die Hemmschichten sind insbesondere Korrosionseigenschaften und Hafteigenschaften für nachfolgende Schichten zu beachten.

Da auch auf der Oberfläche einer Leiterplatte Potentialdifferenzen auftreten können, die Anlass für eine schädliche Elektromigration darstellen können, bietet es sich an, auch auf den freiliegenden Kupferschichten auf der Oberfläche der Leiterplatte jeweils eine Hemmschicht vorzusehen. Auch hier bietet sich eine vollständige (also auch seitliche) Abdeckung der freiliegenden Kupfer- bzw. Metallschichten an. Bei Leiterplatten mit einer sogenannten Stopplackabdeckung wird zwischen der außenliegenden Kupferstruktur und dem Stopplack eine Hemmschicht vorgesehen. In den stopplackfreien Bereichen kann diese Hemmschicht von der Hemmschicht unter dem Stopplack verschieden sein. Kriterien für das jeweilige Material sind Kosten, Löteigenschaften, Hafteigenschaften, oder allgemein die Anpassung der Eigenschaften an die weitere Be- oder Verarbeitung auf dieser oberen Schicht.

Die erfindungsgemäß ausgebildete Leiterplatte weist gegenüber bekannten Leiterplatten verringerte CAF-Effekte auf, so dass ihre Lebensdauer signifikant erhöht ist und ggf. gefährliche Ausfälle im Betrieb deutlich reduziert sind. Gemäß der Erfindung werden CAF-Effekte zwischen den elektrisch leitenden Kupferschichten bzw. -strukturen bzw. (soweit vorhanden) zwischen den elektrisch leitenden Kupferschichten und mindestens einer Durchkontaktierung und/oder mindestens einer vergrabenen Bohrung, aber auch zwischen Durchkontaktierungen bzw. vergrabenen Bohrungen und/oder zwischen weiteren leitenden Strukturen vermieden oder zumindest verringert.

Weitere Vorteile und Ausgestaltungen der Erfindung ergeben sich aus der Beschreibung und der beiliegenden Zeichnung.

Es versteht sich, dass die voranstehend genannten und die nachstehend noch zu erläuternden Merkmale nicht nur in der jeweils angegebenen Kombination, sondern auch in anderen Kombinationen oder in Alleinstellung verwendbar sind, ohne den Rahmen der vorliegenden Erfindung zu verlassen.

Die Erfindung ist anhand von Ausführungsbeispielen in der Zeichnung schematisch dargestellt und wird im Folgenden unter Bezugnahme auf die Zeichnung ausführlich beschrieben. Es ist festzuhalten, dass die Darstellungen in den Figuren der Zeichnung stark schematisch und nicht maßstabsgerecht sind. Zudem sind die einzelnen Schichtlagen der dargestellten Leiterplattenstrukturen zu Zwecken der besseren Erkennbarkeit stark überhöht dargestellt.

### Kurzbeschreibung der Zeichnung

Figur 1 zeigt in schematischer Schnittdarstellung ein Ausführungsbeispiel einer erfindungsgemäßen mehrlagigen Leiterplatte.
Figur 2 zeigt in schematischer Schnittdarstellung ein alternatives Ausführungsbeispiel einer erfindungsgemäßen mehrlagigen Leiterplatte mit einem Sackloch.
Figur 3 zeigt einen Ausschnitt aus der Leiterplatte der Figur 2 mit einem alternativ ausgeführten Sackloch als weiteres Ausführungsbeispiel.
Figur 4 zeigt als weiteres Ausführungsbeispiel in schematischer Schnittdarstellung eine zweilagige Leiterplatte gemäß der Erfindung.
Figur 5 zeigt in schematischer Schnittdarstellung als weiteres Ausführungsbeispiel einen Ausschnitt einer Oberfläche einer erfindungsgemäßen Leiterplatte mit Stopplackabdeckung.

### Ausführliche Beschreibung

Einander entsprechende Teile sind in allen Figuren mit den gleichen Bezugszeichen versehen.

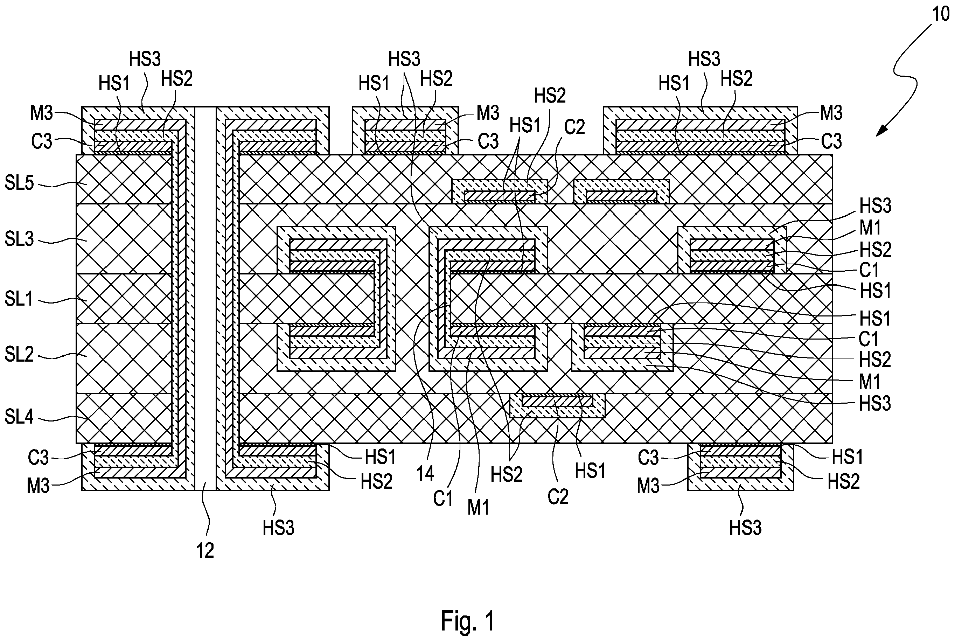

Figur 1 zeigt eine schematische Schnittdarstellung eines Ausführungsbeispiels einer erfindungsgemäßen Leiterplatte 10. Die Schnittebene der Darstellung verläuft im Wesentlichen senkrecht zu einer durch die Leiterplatte 10 aufgespannte Erstreckungsebene.

Die Leiterplatte 10 weist einen an sich bekannten Schichtaufbau aus einer Mehrzahl von elektrisch isolierenden Substratlagen SL1, SL2, SL3, SL4 und SL5 auf, nämlich eine zentrale Substratlage SL1, unter- bzw. oberhalb der zentralen Lage angeordnete innenliegende Substratlagen SL2, SL3 sowie jeweils an die beiden innenliegenden Substratlagen SL2, SL3 angrenzende außenliegende Substratlagen SL4, SL5. Die Substratlagen SL1 bis SL5 sind bspw. aus einem glasfaserverstärkten Epoxidharz gebildet. Die Substratlagen SL1 bis SL5 sind fest miteinander verbunden, beispielsweise durch Verpressen oder Verkleben.

Die Substratlagen SL1 bis SL5 weisen elektrisch leitende Kupferschichten C1, C2 und C3 auf. Die elektrisch leitenden Kupferschichten C1 bis C3 bilden elektrisch leitende Strukturen oder Schichten innerhalb der Leiterplatte 10. Insbesondere dienen die Kupferschichten C1 bis C3 als Leiterbahnen oder Leiterzüge und dienen der elektrischen Verbindung nicht dargestellter elektronischer Bauteile, mit denen die Leiterplatte 10 bestückt ist und die eine Schaltungsanordnung bilden. So können auf einer oder beiden der außenliegenden Substratlagen SL4, SL5 elektronische Bauteile (nicht dargestellt), wie bspw. Transistoren, Widerstände, Halbleiterkomponenten und dergleichen mehr, mittels Löten, Bonden und/oder Verkleben angeordnet und elektrisch mit den elektrisch leitenden Kupferschichten verbunden sein.

Erfindungsgemäß weisen die Kupferschichten C1 bis C3 auf einer Unterseite und einer Oberseite jeweils eine untere Hemmschicht HS1 bzw. eine obere Hemmschicht HS2 auf. Unter Hemmschicht wird vorliegend eine Schicht aus einem Material verstanden, das zur Hemmung einer Elektromigration aus der benachbarten Metall-(Kupfer-)Schicht geeignet ist. Derartige Materialien können (nicht abschließend) Zink, Messing, Nickel-Verbindungen wie Nickel-Gold (NiAu) oder Nickel-Palladium-Gold (NiPdAu) oder auch Zinn oder nichtmetallische Materialien sein.

Unter den Begriffen "Unterseite" und "Oberseite" einer Kupferschicht ist vorliegend eine zur zugehörigen Substratlage weisende oder substratnahe Oberfläche (Unterseite) bzw. von der zugehörigen Substratlage wegweisende oder substratferne Oberfläche (Oberseite) zu verstehen, unabhängig davon, ob die Kupferschicht oberhalb oder unterhalb der Substratlage aufgebracht ist (also unabhängig von der Orientierung der Darstellung in der Figur). Oder mit anderen Worten: die Begriffe "Unterseite" und "Oberseite" sind unabhängig von "oben" und "unten" in der Figurendarstellung, sondern bezeichnen die Relation zwischen Substratlage und Kupferschicht.

Um, wie bereits eingangs erläutert, die Kupferschichten C1 bis C3 zu verstärken und/oder deren Leitfähigkeit zu erhöhen, können alle oder einzelne der Kupferschichten C1 bis C3 mit einer weiteren Metallschicht beschichtet sein. In dem dargestellten Ausführungsbeispiel sind die ersten Kupferschichten C1 auf der zentralen Substratlage SL1 und die dritten Kupferschichten C3 auf den äußeren Substratlagen SL4 bzw. SL5 mit einer weiteren Metallschicht M1 bzw. M3 auf ihrer jeweiligen Hemmschicht versehen. Es können jedoch auch weniger oder weitere Kupferschichten mit einer weiteren Metallschicht versehen sein.

Im Falle von Bohrungen (Durchkontaktierungen, Vias, vergrabene Bohrungen, Sacklöcher) stellt die weitere Metallschicht die im Stand der Technik übliche Metallisierung der Bohrungsinnenwandung dar.

Erfindungsgemäß ist die weitere Metallschicht auf der jeweiligen oberen Hemmschicht HS2 der entsprechenden Kupferschicht C1, C3 aufgebracht. Auf der weiteren Metallschicht M1, M3 ist eine weitere Hemmschicht HS3 aufgebracht. Neben einem Schutz vor dem CAF-Effekt ist damit auch ein Korrosionsschutz verbunden.

Im Falle der weiteren Hemmschicht HS3 auf den Außenlagen, d.h. der freiliegenden Hemmschicht, bietet es sich an, diese aus einem korrosionsbeständigen und/oder gut lötbaren Material (bzw. einer Materialabfolge) zu gestalten, wie bspw. NiAu oder NiPdAu. Alternativ ist auch hier eine zink- oder zinnhaltige Schicht möglich. Wie bereits angedeutet, ist es aber auch möglich, diese freiliegende Hemmschicht direkt auf der Kupferschicht C3 auszubilden, wenn eine erforderliche Leitfähigkeit dieser Kupferschicht auch ohne weitere Metallschicht M3 erreicht wird.

Der Fachmann kann in Rahmen seines fachmännischen Könnens und abhängig von den Design- und verfahrenstechnischen Anforderungen entscheiden, ob die Hemmschichten sämtlich aus dem gleichen Material oder aus unterschiedlichen Materialien bestehen sollen. Grundsätzlich sind beliebige Materialkombinationen von Hemmschichten innerhalb einer Leiterplatte möglich.

In dem dargestellten Ausführungsbeispiel sind außenliegende Kupferstrukturen C3 mittels einer Durchkontaktierung 12 elektrisch leitend miteinander verbunden. Die Durchkontaktierung 12 ist durch eine Bohrung durch die Substratlagen SL1 bis SL5 hergestellt. Als erste Schicht im Inneren der Bohrung ist die Hemmschicht HS2 vorgesehen, mit der auch die äußere Kupferschicht C3 beschichtet ist. Dies hat den Effekt, dass die anschließend zur Erhöhung der elektrischen Leitfähigkeit vorgesehene weitere Metallschicht M3 gegenüber anderen elektrisch leitfähigen Strukturen in der mehrlagigen Leiterplatte 10 gegen CAF-Effekte geschützt ist (diese Hemmschicht HS2 stellt somit die untere Hemmschicht für die weitere Metallschicht M3 dar, während sie in Bezug auf die äußere Kupferschicht C3 gleichzeitig die obere Hemmschicht darstellt). Die Hemmschicht HS2 kann in einem Arbeitsschritt sowohl auf der Kupferschicht C1/C3 als auch auf der Bohrungsinnenwand aufgebracht werden. Es kann sich aber auch anbieten, die Hemmschicht auf der Kupferschicht C1/C3 und auf der Bohrungsinnenwand in getrennten Arbeitsschritten aufzubringen, bspw. wenn unterschiedliche Materialien gewünscht sind.

Auf der weiteren Metallschicht M3 in der Bohrung 12 ist dann die Hemmschicht HS3 der außenliegenden Substratlagen SL4 und SL5 aufgebracht, die bspw. (wie bereits erwähnt) als Nickel-Gold-Schicht oder Nickel-Palladium-Gold-Schicht oder auch als Zinkschicht oder Messingschicht ausgebildet sein kann.

Die auf den beiden innenliegenden Substratlagen SL2 und SL3 aufgebrachten elektrisch leitenden Kupferschichten C2 weisen auf ihrer Oberseite auch eine dünne Hemmschicht HS2 auf, die vorzugsweise korrosionsbeständig ist. Eine Lötbarkeit dieser Hemmschicht HS2 auf den innenliegenden Kupferschichten C2 ist nicht zwingend erforderlich, da auf diesen Kupferschichten keine elektronischen Bauteile aufgebracht werden. Sollte eine Bestückung innenliegender Oberflächen mit elektronischen Bauelementen vorgesehen sein, wäre entsprechend eine gute Lötbarkeit auch der innenliegenden Hemmschicht HS2 erforderlich.

In dem dargestellten Ausführungsbeispiel ist die Hemmschicht HS2 auf der innenliegenden Kupferschicht C2 aus einer Zinkschicht oder Messingschicht gebildet. Zink und Messing eignen sich besonders gut als Korrosionsschutz und bilden auf den elektrisch leitenden Kupferstrukturen eine Barriere gegen das Herauslösen von Kupferbestandteilen der elektrisch leitenden Kupferstrukturen. Damit wird der CAF-Effekt zuverlässig vermieden oder zumindest minimiert.

Das dargestellte Ausführungsbeispiel weist darüber hinaus noch eine sogenannte vergrabene Bohrung 14, auch bekannt als "buried via", auf. Mittels der vergrabenen Bohrung 14 werden innenliegende Kupferstrukturen C1 der zentralen Substratlage SL1 elektrisch leitend miteinander verbunden. Die vergrabene Bohrung 14 weist analog zu der Durchkontaktierung 12 an einer Innenwandung eine dünne Hemmschicht HS2 zur zuverlässigen Vermeidung oder zumindest zur Minimierung des CAF-Effekts auf. Auf der Hemmschicht HS2 ist eine weitere Metallschicht M1 aufgebracht, auf der wiederum eine Hemmschicht HS3 vorgesehen ist, um auch die weitere Metallschicht M1 gegen den CAF-Effekt zu schützen. Somit weisen sowohl die Basis-Kupferschicht C1 als auch die weitere Metallschicht M1 jeweils beidseitig eine Hemmschicht auf, wobei die obere Hemmschicht der Kupferschicht die untere Hemmschicht der weiteren Metallschicht darstellt.

Das Ausführungsbeispiel der Figur 1 dient lediglich Veranschaulichungszwecken. Insbesondere ist festzuhalten, dass die Erfindung nicht auf die dargestellte Kombination von innen- und außenliegenden Schichten sowie Durchkontaktierungen und vergrabenen Bohrungen beschränkt ist, sondern dass beliebige Kombinationen dieser Elemente dem Fachmann bei der Konzeption eines Leiterplattenaufbaus zur Verfügung stehen.

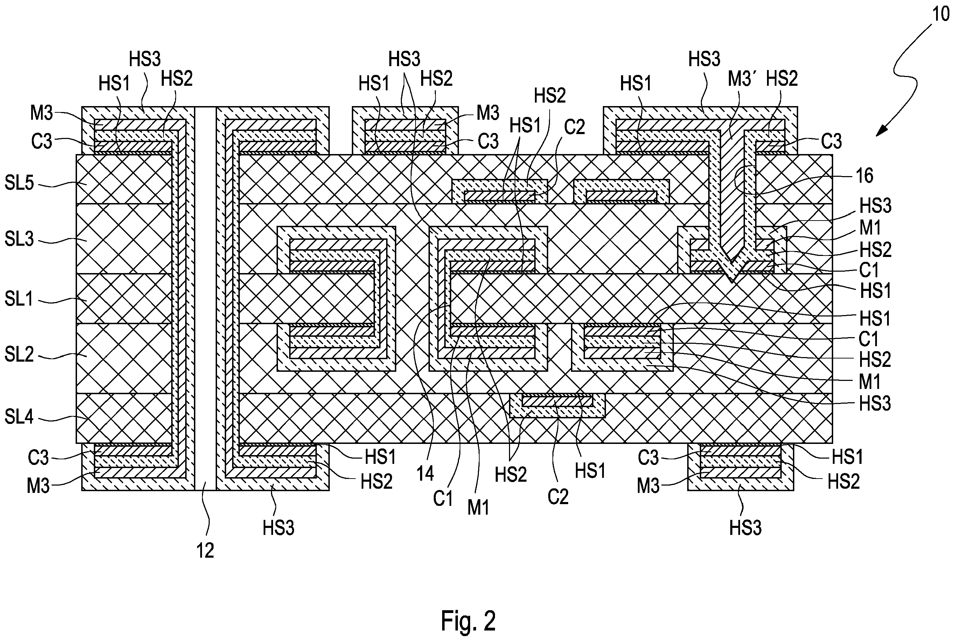

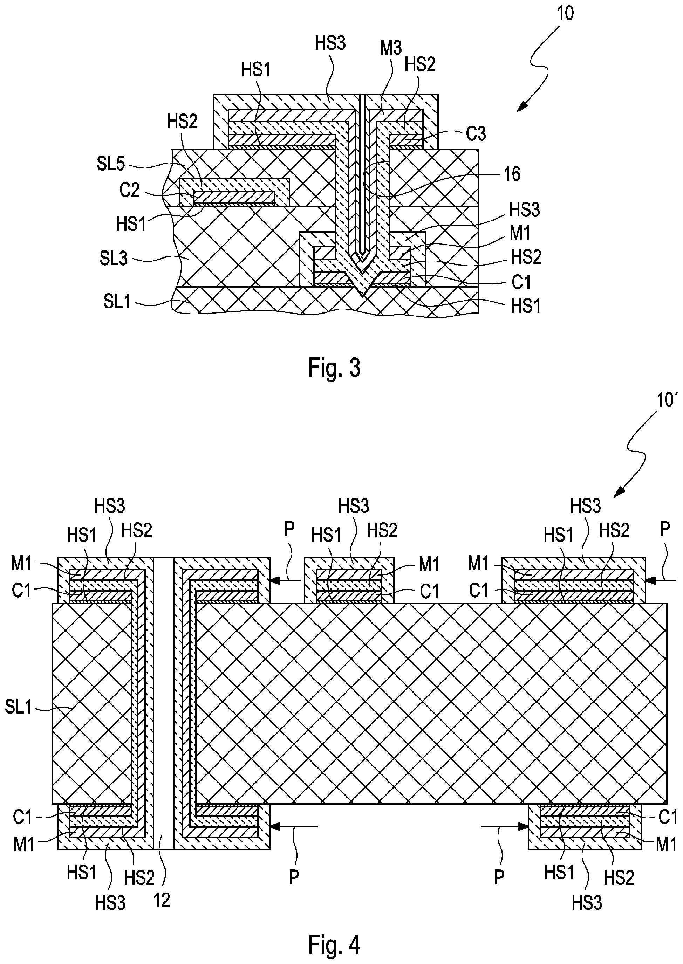

In den Ausführungsbeispielen der Figuren 2 und 3 weist die Leiterplatte 10 zusätzlich noch ein sogenanntes Sackloch 16 (blind via) auf. Das Sackloch 16 verbindet in elektrisch leitender Weise die elektrisch leitende Kupferschicht C3 der (in der Darstellung der Figuren) oberen außenliegenden Substratlage SL5 mit der elektrisch leitenden Kupferschicht C1 der zentralen Substratlage SL1. Des Weiteren ist das Sackloch 16 mit einer analog zu der beschriebenen Hemmschicht HS2 der Durchkontaktierung 12 ausgebildeten Hemmschicht HS2 versehen, die direkt auf eine Innenwandung des Sacklochs 16 aufgebracht ist.

Geeigneterweise werden die Hemmschichten HS2 der Durchkontaktierung 12 und des Sacklochs 16 im Herstellungsverfahren gleichzeitig abgeschieden. Alternativ kann dies aber auch zu unterschiedlichen Zeitpunkten erfolgen.

Zur Erhöhung der elektrischen Leitfähigkeit ist die Hemmschicht HS2 mit einer weiteren Metalllage beschichtet. Im Falle des Ausführungsbeispieles der Figur 2 kann es sich dabei um eine vollständige Metallfüllung M3' handeln. Alternativ dazu kann es sich aber auch um eine die Vertiefung des Sacklochs 16 nachahmende Metallschicht M3 handeln, wie dies in Figur 3 beispielhaft gezeigt ist. Bei beiden Varianten schließt sich dann wieder eine Hemmschicht HS3 auf der Metalllage M3 bzw. M3' an. Im Beispiel der Figur 2 schließt die Hemmschicht HS3 das Sackloch 16 horizontal ab, während im Beispiel der Figur 3 die Hemmschicht HS3 entlang der Metallschicht M3 in das Sackloch 16 hinein verläuft.

Wie aus den Darstellungen der Figuren 2 und 3 ersichtlich, ist die Hemmschicht HS2 des Sacklochs 16 auf die obere außenliegende Substratlage SL5 herausgeführt und verläuft in einem Abschnitt parallel zu der Oberfläche der Substratlage SL5 und bedeckt dabei die auf der oberen außenliegenden Substratlage SL5 angeordnete Kupferschicht C3. Dieser herausgeführte Abschnitt der Hemmschicht HS2 wiederum ist mit einem Material der Metallfüllung M3, M3' versehen, welches schichtartig auf dem außenliegenden Abschnitt der Hemmschicht HS2 aufgebracht ist.

Figur 4 zeigt als weiteres Ausführungsbeispiel in schematischer Schnittdarstellung eine zweilagige Leiterplatte 10' gemäß der Erfindung mit nur einer Substratlage SL1 und einer Durchkontaktierung 12.

Die Leiterplatte 10' des Ausführungsbeispiels der Figur 4 ist als doppelseitige Leiterplatte ausgebildet, auf deren gegenüberliegenden äußeren Oberflächen elektrisch leitende Kupferstrukturen C1 aufgebracht sind, die mittels der Durchkontaktierung 12 elektrisch leitend miteinander verbunden sind.

Zur Herstellung einer erfindungsgemäßen Leiterplatte kommen dem Fachmann an sich bekannte Materialien und Verfahrensabläufe zum Einsatz, die daher im Folgenden nicht im Einzelnen und ausführlich erläutert werden müssen.

Im einfachen Fall des in der Figur 4 dargestellten Ausführungsbeispiels wird eine Substratlage SL1 bereitgestellt, auf der eine erste Kupferschicht C1 in an sich bekannter Weise aufgebracht oder abgeschieden wird, nachdem eine erste Hemmschicht HS1 aufgebracht wurde. Alternativ kann die Kupferschicht C1 anhand einer Kupferfolie aufgebracht werden, die auf einer Seite bereits eine Lage mit einem als Hemmschicht geeigneten Material aufweist. Schließlich kann als weitere Alternative eine kupferkaschierte Substratlage bereitgestellt werden, auf der ebenfalls bereits eine als Hemmschicht geeignete Lage unter der Kupferschicht (d.h. zwischen Substratschicht und Kupferschicht) vorhanden ist. Typischerweise sind geeignete Kupferfolien mit einer Messingbeschichtung zur Verbesserung der Hafteigenschaften der Cu-Folie im Handel erhältlich.

Anschließend wird eine weitere Hemmschicht (Hemmschicht HS2) auf die Kupferschicht C1 aufgebracht. Dies kann stromlos oder galvanisch erfolgen (bspw. stromlose Zinkabscheidung oder chemische Abscheidung von Messing) jeweils mit vorgegebener Schichtdicke von mindestens 100 nm, typischerweise von 100 nm bis 1.500 nm. Denkbar wäre es auch, Messing bei Durchführung eines thermischen Prozesses während der Herstellung der mehrlagigen Leiterplatte aus den Cu-Strukturen und einer Zinkbeschichtung zu erzeugen.

Im Falle der Anbringung einer Durchbohrung wie im Falle der Durchkontaktierung 12 der Figur 4 erfolgt der Schritt des Bohrens vor dem Aufbringen der zweiten oder oberen Hemmschicht HS2. Dann kann darauffolgend die Hemmschicht HS2 auch zum Bedecken der Innenwandung der Durchkontaktierung in die Bohrung in einem Verfahrensschritt eingebracht werden (nachdem in dem Fachmann bekannter Weise zuvor die Innenwandung gereinigt und abscheidungsfähig gemacht wurde). Die Hemmschicht HS2 kann auf der Innenwandung der Durchkontaktierung (bzw. auch der vergrabenen Bohrung gemäß den Ausführungsbeispielen der Figuren 1 und 2) chemisch abgeschieden werden. Beispielsweise erfolgt dies mit chemischer Badabscheidung. Die elektrisch nicht leitfähige Bohrlochwandung wird dazu vorher mittels eines dem Fachmann bekannten Verfahrens der Leiterplattentechnik leitfähig gemacht, um diese mittels galvanischem Prozess mit der Hemmschicht zu versehen.

Auf die Hemmschicht kann anschließend die weitere Metallschicht M1 galvanisch abgeschieden werden. Dazu wird beispielsweise Kupfer auf der Hemmschicht abgeschieden. Die Hemmschicht besteht in diesen Fällen aus einem geeigneten Metall bzw. einer geeigneten Metallverbindung, wodurch die folgende galvanische Abscheidung ermöglicht wird.

In einem Ätzprozess werden durch Ätzen der aufgebrachten Lagen bis auf die Substratlage die gewünschten Leiterstrukturen geschaffen, und in einem nächsten Schritt erfolgt die Abscheidung einer weiteren (im Falle des Beispiels der Figur 4 äußeren) Hemmschicht HS3. Die weitere Hemmschicht HS3 wird derart aufgebracht, dass sie die Leiterstrukturen vollständig, d.h. nicht nur auf der Oberfläche, sondern auch seitlich (Leiterflanken) bedeckt, wie dies in den Figuren gut erkennbar und in Figur 4 mittels eingezeichneter Pfeile P verdeutlicht ist. Insbesondere erstreckt sich die weitere Hemmschicht HS3 auch durch die gesamte Durchkontaktierung 12 (oder auch die vergrabene Bohrung 14 der Figur 1).

Soll eine Leiterplatte mehrere Substratlagen umfassen, wiederholt sich der beschriebene Vorgang, indem die erste (zentrale) Substratlage SL1 mit den darauf geschaffenen Strukturen mit weiteren Substratlagen SL2, SL3 verpresst wird, auf denen wiederum entsprechend weitere Kupferlagen aufgebracht und/oder Bohrungen vorgenommen werden. So könnte bspw. die im Ausführungsbeispiel der Figur 4 gezeigte Leiterplatte als Basis für das Verpressen mit weiteren darüber und darunter angebrachten Substratlagen dienen. Durch Eindringen von beim Verpressvorgang verflüssigtem Harz in die Durchbohrung wird dann eine vergrabene Bohrung geschaffen.

Auf elektrisch leitende Kupferschichten außenliegender Substratlagen (wie die Kupferschicht C1 im Ausführungsbeispiel der Figur 4 oder die Kupferschicht C3 im Falle der Ausführungsbeispiele der Figuren 1 bis 3) wird vorzugsweise ebenfalls jeweils ein Metall oder eine Metallverbindung zur Ausbildung einer außenliegenden Hemmschicht HS3 bspw. stromlos abgeschieden. Beispielsweise wird als Metallverbindung eine Nickel-Gold-Verbindung chemisch abgeschieden. Bei der Hemmschicht außenliegender Kupferschichten ist zusätzlich eine Lötbarkeit des Materials zu beachten, weshalb Nickel-Gold besonders geeignet ist. Alternativ kann auch ein kostengünstigeres Material, wie z.B. Zink oder Zinn, verwendet werden.

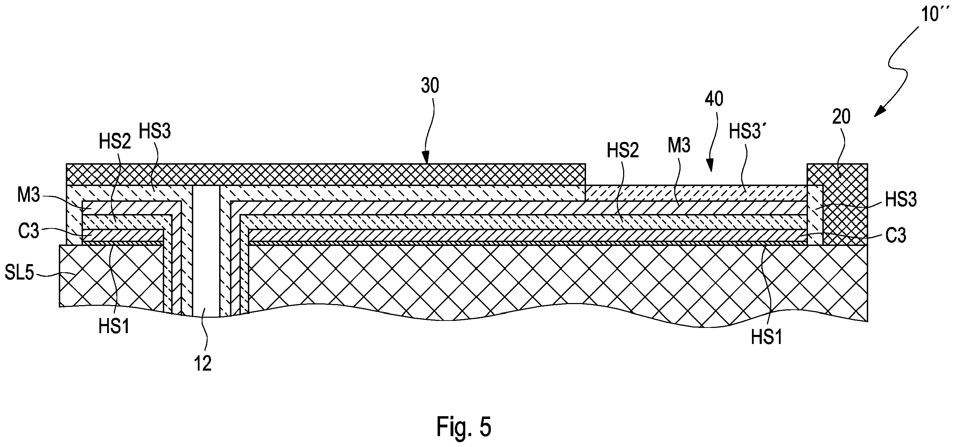

Bei Leiterplatten, bei denen eine Stopplackabdeckung auf der Oberfläche vorzusehen ist, kann bspw. wie in dem in Figur 5 dargestellten weiteren Ausführungsbeispiel vorgegangen werden.

Figur 5 zeigt in schematischer Schnittdarstellung im Ausschnitt eine Oberfläche einer erfindungsgemäßen Leiterplatte 10" mit einer auf der Oberfläche aufgebrachten Stopplackabdeckung 20. Ähnlich wie im Ausführungsbeispiel der Figur 1 weist die Leiterplatte 10" auf der in der Darstellung der Figur 5 linken Seite eine Durchkontaktierung 12 auf. Auf der Oberfläche der Leiterplatte, d.h. auf der Oberseite der oberen Substratlage SL5, bildet die erfindungsgemäße Schichtenfolge einer unteren Hemmschicht HS1, einer Kupferschicht C3, einer oberen Hemmschicht HS2, einer weiteren Metallschicht M3 sowie einer weiteren Hemmschicht HS3 eine Leiterbahn 30, die zu einer Anschlussstelle 40 auf der rechten Seite der Leiterplatte 10" führt. Die Anschlussstelle 40 ist stopplackfrei und im Übrigen von der Stopplackabdeckung 20 umgeben.

Zur Ausbildung der Anschlussstelle 40 wird wie folgt vorgegangen: Nach dem Aufbringen der weiteren Metallschicht M3 wie beschrieben und dem anschließenden Ätzvorgang zur Ausbildung der Leiterbahn 30 wird eine Hemmschicht HS3 aufgebracht, die die weitere Metallschicht und auch (an den Rändern) die darunterliegenden Schichten vollständig bedeckt. Bei der Hemmschicht HS3 handelt es sich vorzugsweise um ein kostengünstiges, aber die Hemmung der Elektromigration gut realisierendes Material, wie bspw. Zink oder Messing. Dann wird die Hemmschicht HS3 und die gesamte Oberfläche der Leiterplatte 10" mit der Stopplackabdeckung 20 überzogen. Im Bereich der auszubildenden Anschlussstelle wird der Stopplack entfernt, d.h. die Anschlussstelle wird freigelegt. Daraufhin wird in dem freigelegten Bereich die weitere Hemmschicht HS3 aus Zink oder Messing wieder entfernt und es wird als alternatives Material eine weitere Hemmschicht HS3' aus Nickel oder einer Nickel-Verbindung bzw. einer Nickel oder eine Nickel-Verbindung umfassenden Schichtabfolge aufgebracht (NiAu oder NiPdAu). Auf dieser Anschlussstelle 40 kann dann ein bzw. der Lötprozess, ein Klebe- oder ein Drahtbond-Prozess durchgeführt werden. Kriterien für die Materialauswahl sind hierbei neben den Kosten (eine Schicht aus Zink oder Messing ist deutlich günstiger als eine Gold oder Palladium umfassende Schichtabfolge) die jeweiligen Eigenschaften der Materialien im Hinblick auf die weitere Be- bzw. Verarbeitung auf der jeweiligen Hemmschicht (wie Hafteigenschaften für Lötstopplack, Löteigenschaften für die Anschlussstelle, usw.).

Selbstverständlich kann das beschriebene Vorgehen auch in anderer Geometrie oder mit anderem Schichtaufbau, bspw. ohne weitere Metallschicht M3, realisiert werden.

## Patentansprüche

1. Leiterplatte (10, 10', 10") mit mindestens einer isolierenden Substratlage (SL1, SL2, SL3, S14, SL5) und einer Mehrzahl von auf der mindestens einen isolierenden Substratlage (SL1, SL2, SL3, S14, SL5) angeordneten elektrisch leitenden Kupferschichten (C1, C2, C3), wobei mindestens eine der elektrisch leitenden Kupferschichten (C1, C2, C3) zumindest beidseitig mit einer Schicht (HS1, HS2, HS3) aus einem Material zur Hemmung von Elektromigration beschichtet ist, wobei auf einer Schicht (HS1, HS2) aus einem Material zur Hemmung von Elektromigration eine weitere Metallschicht (M1, M2, M3, M3') vorgesehen ist, die wiederum mit einer weiteren Schicht (HS3, HS3') aus einem Material zur Hemmung von Elektromigration beschichtet ist.

2. Leiterplatte (10, 10', 10") nach Anspruch 1, bei der mindestens eine mindestens zwei Kupferschichten (C1, C2, C3) verbindende Bohrung (12, 14, 16) vorgesehen ist, auf deren Innenwandung eine Schicht (HS2) aus einem Material zur Hemmung von Elektromigration aufgebracht ist.

3. Leiterplatte (10, 10', 10") nach Anspruch 2, bei der die Bohrung eine Durchkontaktierung (12), eine vergrabene Bohrung (14) und/oder ein Sackloch (16) ist.

4. Leiterplatte (10, 10', 10") nach einem der Ansprüche 1 bis 3, bei der das Material zur Hemmung von Elektromigration Zink, Messing, eine Nickel oder eine Nickel-Verbindung umfassende Schichtabfolge wie bspw. Nickel-Gold oder Nickel-Palladium-Gold, Zinn, und/oder ein Polymer o.a. ist.

5. Leiterplatte (10") nach einem der Ansprüche 1 bis 4, die eine Stopplackabdeckung (20) aufweist, wobei zwischen einer obersten Kupferschicht (C3) und der Stopplackabdeckung (20) eine Schicht (HS3) aus einem Material zur Hemmung von Elektromigration vorgesehen ist.

6. Leiterplatte (10") nach Anspruch 5, bei der ein zur Ausbildung einer Anschlussstelle (40) dienender Bereich keine Stopplackabdeckung aufweist und ein Oberflächenmaterial der Anschlussstelle (40) durch eine Hemmschicht (HS3') aus einem Material (HS3') zur Hemmung von Elektromigration gebildet ist, das ein anderes Material ist, als das Material der unter der Stopplackabdeckung (20) vorgesehenen Schicht (HS3) aus einem Material zur Hemmung von Elektromigration.

7. Verfahren zum Herstellen einer Leiterplatte (10, 10', 10"), mit den folgenden Schritten:
- Ausbilden einer Schichtabfolge aus einer Substratlage (SL1) und einer Kupferschicht (C1) mit einer dazwischenliegenden Schicht (HS1) aus einem Material zur Hemmung von Elektromigration,
- Aufbringen einer oberen Schicht (HS2) aus einem Material zur Hemmung von Elektromigration auf die Kupferschicht (C1),
- Abscheiden einer weiteren Metallschicht (M1) auf die obere Schicht (HS2) aus einem Material zur Hemmung von Elektromigration,
- Ätzen der gebildeten Schichtenfolge zum Ausbilden von Leiterstrukturen,
- Abscheiden einer weiteren Schicht (HS3) aus einem Material zur Hemmung von Elektromigration.

8. Verfahren nach Anspruch 7, bei dem der Schritt des Ausbildens folgende Schritte umfasst:
- Bereitstellen einer Substratlage (SL1),
- Aufbringen einer Schicht (HS1) aus einem Material zur Hemmung von Elektromigration auf die Substratlage (SL1),
- Aufbringen einer Kupferschicht (C1).

9. Verfahren nach Anspruch 7, bei dem der Schritt des Ausbildens folgende Schritte umfasst:
- Bereitstellen einer Substratlage (SL1),
- Bereitstellen einer Kupferfolie, die eine Haftschicht aus einem zur Hemmung von Elektromigration geeigneten Material aufweist,
- Aufbringen der Kupferfolie auf die Substratlage (SL1) derart, dass die Haftschicht zur Bildung einer Hemmschicht (HS1) aus einem zur Hemmung von Elektromigration geeigneten Material auf der Substratlage (SL1) aufgebracht wird und zwischen der Substratlage (SL1) und einer durch die Kupferfolie gebildeten Kupferschicht (C1) zu liegen kommt.

10. Verfahren nach Anspruch 7, bei dem der Schritt des Ausbildens im Bereitstellen einer kupferkaschierten Substratlage (SL1) besteht, bei der zwischen einer Kupferlage zur Bildung einer Kupferschicht C1 eine Schicht (HS1) aus einem zur Hemmung von Elektromigration geeigneten Material vorgesehen ist.

11. Verfahren nach Anspruch 7, das zur Ausbildung von Bohrungen in der Leiterplatte (10, 10', 10") nach dem Schritt des Ausbildens der Schichtabfolge den folgenden zusätzlichen Schritt umfasst:
- Bohren der Substratlage (SL1) mit Kupferschicht (C1) und dazwischenliegender Schicht (HS1) aus einem Material zur Hemmung von Elektromigration.

12. Verfahren nach einem der Ansprüche 7 bis 11, bei dem zur Bildung weiterer Leiterplattenlagen die entstandene Schichtenfolge mit weiteren Substratlagen (SL2, SL3; SL4, SL5) verpresst wird, und anschließend die Verfahrensschritte nach einem der Ansprüche auf diesen Substratlagen wiederholt werden.

13. Verfahren nach einem der Ansprüche 7 bis 12, bei dem das Material zur Hemmung von Elektromigration ausgewählt ist aus der Gruppe umfassend Zink, Messing, Nickel bzw. Nickel-Verbindungen, bspw. in Schichtabfolgen wie Nickel-Gold, Nickel-Palladium-Gold, Zinn, u.a.

14. Verfahren nach Anspruch 13, bei dem innenliegende Hemmschichten aus Zink oder Messing oder Nickel-Verbindungen gebildet werden und außenliegende Schichten aus Nickel-Verbindungen gebildet werden.

15. Verfahren nach einem der Ansprüche 7 bis 13, das zur Ausbildung einer von Stopplack (20) umgebenen Anschlussstelle (40) auf der Leiterplatte (10") folgende weiteren Schritte umfasst:
- Aufbringen einer Stopplackabdeckung (20) auf einer außenliegenden Hemmschicht (HS3) aus einem ersten Material zur Hemmung von Elektromigration auf der Oberfläche einer Leiterplatte (10"),
- Entfernen des Stopplacks (20) in einem als Anschlussstelle (40) vorgesehenen Bereich oberhalb der Hemmschicht (HS3),
- Entfernen des ersten Materials der Hemmschicht (HS3) in dem als Anschlussstelle (40) vorgesehenen Bereich,
- Ausbilden der Anschlussstelle (40) durch Auftragen einer Schicht (HS3') aus einem zweiten Material zur Hemmung von Elektromigration in dem freigelegten Bereich.

## Claims

1. Circuit board (10, 10', 10'') having at least one insulating substrate level (SL1, SL2, SL3, S14, SL5) and a multiplicity of electrically conductive copper layers (C1, C2, C3) arranged on the at least one insulating substrate level (SL1, SL2, SL3, S14, SL5), wherein at least one of the electrically conductive copper layers (C1, C2, C3) is coated at least on both sides with a layer (HS1, HS2, HS3) of a material for inhibiting electromigration, a further metal layer (M1, M2, M3, M3') being provided on a layer (HS1, HS2) of a material for inhibiting electromigration, which further metal layer is in turn coated with a further layer (HS3, HS3') of a material for inhibiting electromigration.

2. Circuit board (10, 10', 10'') according to Claim 1, wherein at least one bore (12, 14, 16) is provided, which connects at least two copper layers (C1, C2, C3) and on the inner wall of which a layer (HS2) of a material for inhibiting electromigration is applied.

3. Circuit board (10, 10', 10'') according to Claim 2, wherein the bore is a through-contact (12), a buried bore (14) and/or a blind hole (16).

4. Circuit board (10, 10', 10'') according to one of Claims 1 to 3, wherein the material for inhibiting electromigration is zinc, brass, a layer sequence comprising nickel or a nickel compound, for example nickel-gold or nickel-palladium-gold, tin, and/or a polymer, etc.

5. Circuit board (10'') according to one of Claims 1 to 4, which has a solder resist covering (20), a layer (HS3) of a material for inhibiting electromigration being provided between an uppermost copper layer (C3) and the solder resist covering (20).

6. Circuit board (10'') according to Claim 5, wherein a region used to form a connection position (40) does not have a solder resist covering, and a surface material of the connection position (40) is formed by an inhibition layer (HS3') of a material (HS3') for inhibiting electromigration, which is a different material than the material of the layer (HS3) of a material for inhibiting electromigration provided below the solder resist covering (20).

7. Method for producing a circuit board (10, 10', 10"), having the following steps:
- forming a layer sequence of a substrate level (SL1) and a copper layer (C1) with a layer (HS1) of a material for inhibiting electromigration lying between them,
- applying an upper layer (HS2) of a material for inhibiting electromigration onto the copper layer (C1),
- depositing a further metal layer (M1) onto the upper layer (HS2) of a material for inhibiting electromigration,
- etching the layer sequence formed, in order to form conductor structures,
- depositing a further layer (HS3) of a material for inhibiting electromigration.

8. Method according to Claim 7, wherein the formation step comprises the following steps:
- providing a substrate level (SL1),
- applying a layer (HS1) of a material for inhibiting electromigration onto the substrate level (SL1),
- applying a copper layer (C1).

9. Method according to Claim 7, wherein the formation step comprises the following steps:
- providing a substrate level (SL1),
- providing a copper foil, which has a bonding layer of a material suitable for inhibiting electromigration,
- applying the copper foil onto the substrate level (SL1) in such a way that the bonding layer is applied in order to form an inhibition layer (HS1) of a material suitable for inhibiting electromigration on the substrate level (SL1) and comes to lie between the substrate level (SL1) and a copper layer (C1) formed by the copper foil.

10. Method according to Claim 7, wherein the formation step consists in providing a copper-masked substrate level (SL1), during which a layer (HS1) of a material suitable for inhibiting electromigration is provided between a copper level for forming a copper layer C1.

11. Method according to Claim 7, which, in order to form bores in the circuit board (10, 10', 10"), comprises the following additional step after the step of forming the layer sequence:
- boring the substrate level (SL1) with the copper layer (C1) and the layer (HS1) of a material for inhibiting electromigration lying between them.

12. Method according to one of Claims 7 to 11, wherein, in order to form further circuit board levels, the resulting layer sequence is pressed together with further substrate levels (SL2, SL3; SL4, SL5), and the method steps according to one of the claims are then repeated on these substrate levels.

13. Method according to one of Claims 7 to 12, wherein the material for inhibiting electromigration is selected from the group consisting of zinc, brass, nickel or nickel compounds, for example in layer sequences such as nickel-gold, nickel-palladium-gold, tin, etc.

14. Method according to Claim 13, wherein innerlying inhibition layers are formed from zinc or brass or nickel compounds, and outer-lying layers are formed from nickel compounds.

15. Method according to one of Claims 7 to 13, which, in order to form a connection position (40) surrounded by solder resist (20) on the circuit board (10"), comprises the following further steps:
- applying a solder resist covering (20) on an outer-lying inhibition layer (HS3) of a first material for inhibiting electromigration on the surface of a circuit board (10"),
- removing the solder resist (20) in a region intended as a connection position (40) above the inhibition layer (HS3),
- removing the first material of the inhibition layer (HS3) in the region intended as a connection position (40),
- forming the connection position (40) by applying a layer (HS3') of a second material for inhibiting electromigration in the uncovered region.

## Revendications

1. Carte à circuits (10, 10', 10'') comportant au moins une strate de substrat isolante (SL1, SL2, SL3, S14, SL5) et une pluralité de couches de cuivre électriquement conductrices (C1, C2, C3) disposées sur ladite au moins une strate de substrat isolante (SL1, SL2, SL3, S14, SL5), l'une au moins des couches de cuivre électriquement conductrices (C1, C2, C3) étant pourvue au moins sur les deux faces d'une couche (HS1, HS2, HS3) en matériau inhibiteur d'électro-migration, une autre couche métallique (M1, M2, M3, M3') étant prévue sur une couche (HS1, HS2) en matériau inhibiteur d'électro-migration, qui est à son tour revêtue d'une autre couche (HS3, HS3') en matériau inhibiteur d'électro-migration.

2. Carte à circuits (10, 10', 10'') selon la revendication 1,
dans laquelle est prévu au moins un perçage (12, 14, 16) reliant au moins deux couches de cuivre (C1, C2, C3), sur la paroi intérieure duquel est appliquée une couche (HS2) d'un matériau destiné à inhiber l'électro-migration.

3. Carte à circuits (10, 10', 10'') selon la revendication 2,
dans laquelle le perçage est un contact traversant (12), un perçage enterré (14) et/ou un trou borgne (16).

4. Carte à circuits (10, 10', 10'') selon l'une des revendications 1 à 3,
dans laquelle le matériau pour inhiber l'électro-migration est le zinc, le laiton, une séquence de couches comprenant du nickel ou un composé de nickel, tel que le nickel-or ou le nickel-palladium-or, l'étain, et/ou un polymère ou similaire.

5. Carte à circuits (10'') selon l'une des revendications 1 à 4,
présentant un recouvrement de vernis d'arrêt (20), une couche (HS3) d'un matériau pour inhiber l'électro-migration étant prévue entre une couche de cuivre supérieure (C3) et le recouvrement de vernis d'arrêt (20) .

6. Carte à circuits (10") selon la revendication 5, dans laquelle une zone servant pour réaliser un emplacement de jonction (40) ne présente pas de recouvrement de vernis d'arrêt (20), et un matériau de surface de l'emplacement de jonction (40) est formé par une couche d'inhibition (HS3') d'un matériau (HS3') pour inhiber l'électro-migration, qui est un matériau différent du matériau de la couche (HS3) d'un matériau pour inhiber l'électro-migration prévue sous le recouvrement de vernis d'arrêt (20).

7. Procédé de fabrication d'une carte à circuits (10, 10', 10"), comprenant les étapes suivantes consistant à
- former une séquence de couches composée d'une strate de substrat (SL1) et d'une couche de cuivre (C1) avec une couche intermédiaire (HS1) d'un matériau inhibiteur d'électro-migration,
- appliquer une couche supérieure (HS2) d'un matériau pour inhiber l'électro-migration sur la couche de cuivre (C1),
- déposer une autre couche de métal (M1) sur la couche supérieure (HS2) d'un matériau pour inhiber l'électro-migration,
- graver la séquence de couches formée pour former des structures conductrices,
- déposer une autre couche (HS3) d'un matériau pour inhiber l'électro-migration.

8. Procédé selon la revendication 7,
dans lequel l'étape de formation comprend les étapes suivantes consistant à :
- fournir une strate de substrat (SL1),
- appliquer une couche (HS1) d'un matériau pour inhiber l'électro-migration sur la strate de substrat (SL1),
- appliquer une couche de cuivre (C1).

9. Procédé selon la revendication 7,
dans lequel l'étape de formation comprend les étapes suivantes consistant à :
- fournir une strate de substrat (SL1),
- fournir une feuille de cuivre ayant une couche adhésive d'un matériau approprié pour inhiber l'électro-migration,
- appliquer la feuille de cuivre sur la strate de substrat (SL1) de telle manière que la couche adhésive pour la formation d'une couche d'inhibition (HS1) d'un matériau approprié pour l'inhibition de l'électro-migration soit appliquée sur la strate de substrat (SL1) et vienne se placer entre la strate de substrat (SL1) et une couche de cuivre (C1) formée par la feuille de cuivre.

10. Procédé selon la revendication 7,
dans lequel l'étape de formation consiste à fournir une strate de substrat plaquée de cuivre (SL1) dans laquelle une couche (HS1) d'un matériau approprié pour inhiber l'électro-migration est prévue entre une strate de cuivre pour former une couche de cuivre (C1).

11. Procédé selon la revendication 7,
qui, en vue de ménager des perçages dans la carte à circuits (10, 10', 10'') après l'étape de formation de la séquence de couches, comprend l'étape supplémentaire suivante consistant à :
- percer la strate de substrat (SL1) avec sa couche de cuivre (C1) et la couche intermédiaire (HS1) d'un matériau permettant d'inhiber l'électro-migration.

12. Procédé selon l'une des revendications 7 à 11,
dans lequel, en vue de former d'autres strates de carte à circuits, la séquence de couches résultante est pressée avec d'autres strates de substrat (SL2, SL3 ; SL4, SL5), et ensuite les étapes du procédé selon l'une des revendications sont répétées sur ces strates de substrat.

13. Procédé selon l'une des revendications 7 à 12,
dans lequel le matériau destiné à inhiber l'électro-migration est choisi parmi le groupe comprenant le zinc, le laiton, le nickel ou les composés de nickel, par exemple dans des séquences de couches telles que nickel-or, nickel-palladium-or, étain ou similaire.

14. Procédé selon la revendication 13,
dans lequel des couches internes d'inhibition sont formées à partir de composés de zinc ou de laiton ou de nickel et des couches externes sont formées à partir de composés de nickel.

15. Procédé selon l'une des revendications 7 à 13, comprenant les étapes supplémentaires suivantes pour former un emplacement de jonction (40) entouré de vernis d'arrêt (20) sur la carte à circuits (10'') :
- appliquer un recouvrement de vernis d'arrêt (20) sur une couche d'inhibition externe (HS3) d'un premier matériau pour inhiber l'électro-migration à la surface d'une carte à circuits (10"),
- enlever le vernis d'arrêt (20) dans une zone située au-dessus de la couche d'inhibition (HS3) prévue comme emplacement de jonction (40),
- enlever le premier matériau de la couche d'inhibition (HS3) dans la zone prévue comme emplacement de jonction (40),
- former l'emplacement de jonction (40) par l'application d'une couche (HS3') d'un second matériau pour inhiber l'électro-migration dans la zone dégagée.
